(19) Europäisches Patentamt / European Patent Office / Office européen des brevets

(11) **EP 2 090 137 B1**

(12) **EUROPEAN PATENT SPECIFICATION**

(45) Date of publication and mention
of the grant of the patent:
**26.06.2019 Bulletin 2019/26**

(51) Int Cl.:
**H04R 1/40** *(2006.01)*     **H04R 27/00** *(2006.01)*

(21) Application number: **07824169.2**

(22) Date of filing: **16.10.2007**

(86) International application number:
**PCT/GB2007/003918**

(87) International publication number:
**WO 2008/047089 (24.04.2008 Gazette 2008/17)**

(54) **SPEAKER CONFIGURATION**

LAUTSPRECHERKONFIGURATION

CONFIGURATION DE HAUT-PARLEURS

(84) Designated Contracting States:
**AT BE BG CH CY CZ DE DK EE ES FI FR GR HU
IE IS IT LI LT LU LV MC MT NL PL PT RO SE SI
SK TR**

(30) Priority: **16.10.2006 GB 0620488**

(43) Date of publication of application:
**19.08.2009 Bulletin 2009/34**

(73) Proprietor: **Martin Audio Limited
High Wycombe,
Bucks HP12 3SL (GB)**

(72) Inventor: **THOMPSON, Ambrose Charles T.
Aylesbury HP20 1LD (GB)**

(74) Representative: **Abel & Imray
Westpoint Building
James Street West
Bath BA1 2DA (GB)**

(56) References cited:
EP-A2- 1 746 522     US-A- 5 233 664
US-A1- 2005 031 135

• "Display Revealed" THE EDGE, [Online] no. 11,
April 2005 (2005-04), XP002491336 Retrieved
from the Internet:
URL:http://www.martin-audio.com/edge/THE_E
DGE11/p6.html> [retrieved on 2008-07-30]

• AMBROSE THMPSON: "Introducing Wavefront
Line Array EASE DLL's"[Online] 15 November
2004 (2004-11-15), XP002491337 Retrieved from
the Internet:
URL:http://www.martin-audio.com/softtech/I
ntroducing_Martin_Audio_DLLs.pdf>

• "MAPP Online Pro Release Notes"[Online] 2005,
XP002491338 Retrieved from the Internet:
URL:http://www.meyersound.com/products/ma
p ponline/pro/releasenotes.htm> [retrieved on
2008-07-31]

• "MAPP Online Accuracy Confirmed by Test of
Predicted Response" MEYER SOUND
TECHNICAL REPORT, [Online] XP002491339
Retrieved from the Internet:
URL:http://www.meyersound.com/support/pape
rs/meyer_mapp_accuracy.pdf>

• MARK BAILEY: "Experiences with line arrays"
AES, 2003, XP002491340

• ROBERT HOOKE AND T.A. JEEVES: ""Direct
search" solution of numerical and statistical
problems" JOURNAL OF ACM, vol. 8, 1961, pages
212-229, XP002491341 Pittsburgh, PA

• BILL WEBB ET AL: "ADVANCES IN LINE ARRAY
TECHNOLOGY FOR LIVE SOUND", AES UK 18TH
CONFERENCE: LIVE SOUND, 1 April 2003
(2003-04-01), XP055196991,

• AMBROSE THOMPSON: "LINE ARRAY SPLAY
ANGLE OPTIMISATION", PROCEEDINGS OF THE
INSTITUTE OF ACOUSTICS VOL 28 PT. 8:
REPRODUCED SOUND CONFERENCE. 22ND,
vol. 28, 3 November 2006 (2006-11-03),
XP055396816,

**Description**

The present invention relates to the configuration of arrays of speakers.

BACKGROUND

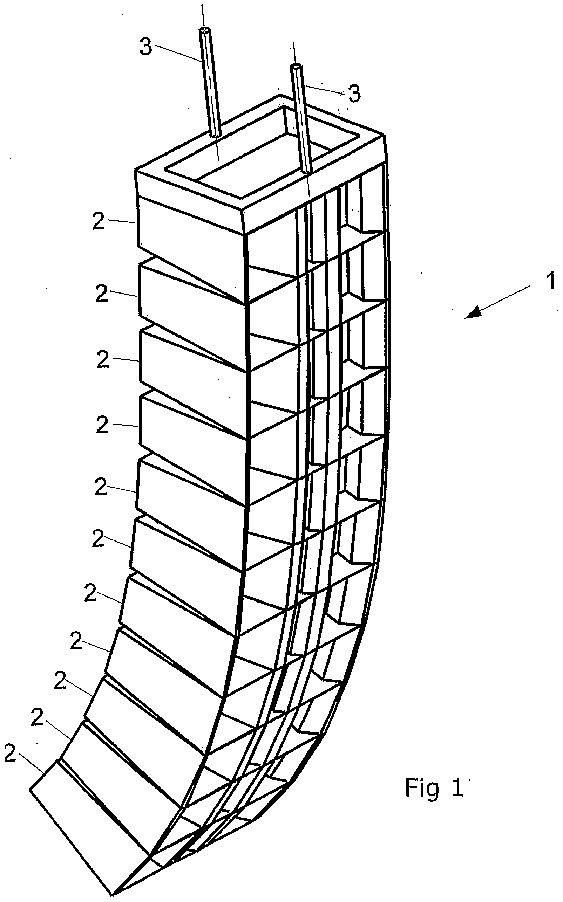

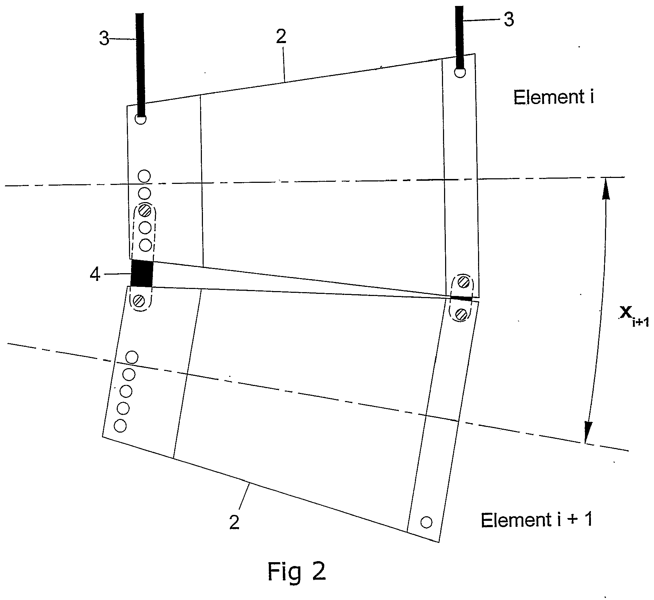

Vertically arrayed loudspeakers systems, or "line arrays", are currently the predominant form of system used in large and medium scale touring sound systems. A typical line array is shown in Figure 1. The line array 1 comprises several loudspeaker elements 2 arranged vertically by being suspended from the ceiling of a venue on suspension chains 3. As shown in Figure 2, the splay angle $x_i$ between neighbouring elements is adjusted by means of an adjustment bar 4 which allows different settings for the spacing between the back of the elements, while the distance between the front of the elements remains fixed.

Due to the complex nature of the interactions of the elemental loudspeakers a wealth of CAD tools is available that predict the output of a given array or combination. Such tools include EASE, form ADA (www.ada-library.de), CATT, from CATT-Acoustic (http://www.catt.se/), and DISPLAY, from Martin Audio (www.martin-audio.com.). These kind of systems have been available for at least 10 years.

To design an array with these tools the user manually alters the splay angles between one element speaker and the next in the array and inspects the output; this process is repeated until an acceptable output is achieved.

Some of the factors important to the success of the manual method of array design are:

1. Accuracy of the radiation model used to predict the output of the array.
2. The user's mental model of how the complete sound system works.
3. Speed of feedback to the user of the CAD system's prediction.
4. Size and granularity of the domain used.
5. Time available for the user to find a solution using the CAD system.

The present invention aims to improve upon this method of configuring speaker arrays for use so that they provide the desired sound field.

The simple radiation model that forms the basis for practically all array CAD tools has been termed the directional point source model. Pressure at the receiver points **r** is formed from the complex summation of pressure from all elemental sources. Each elemental source has an associated measured complex 'balloon' of pressure at a set of frequencies **f** and an orientation. The computation defines a ray from each source to each receiver point, for each frequency the pressure where the ray intersects the balloon is determined via a complex interpolation of nearby measured points, and this pressure is then propagated to the receiver points to provide a pressure amplitude P(**r**,**f**) (H. Staffeldt. Prediction of sound pressure fields of loudspeaker arrays from loudspeaker polar data with limited angular and frequency resolution - 108th Convention of the Audio Engineering Society, Preprint : 5130, 2000). It is assumed that the measured data for each source, which is used to determine the 'balloon', is obtained in the far-field for that source and that the presence of neighbouring enclosures is not significant, since neighbouring enclosures are seldom present when source measurements are performed. Despite the latter assumption the simple model is thought to give a good indication of the expected pressure at the receiver points.

Many users of CAD systems tasked with manual design of vertical arrays only evaluate the performance on a thin strip of the venue normal to the front of the array. This method allows relatively rapid feedback when compared to full audience plane calculations and it is found that good performance on the strip generally reflects in good performance in the full calculation assuming each element has consistent horizontal directionality. The examples of the invention given below follow this convention but the invention also allows for the incorporation of points outside the strip whilst still avoiding a full calculation.

The normal presentation of performance along the strip to the user either employs overlaid frequency responses at different receiver points or overlaid plots of pressure at the receiver points for different frequencies (distance plots). Both of these views become cumbersome when more than 10 graphs are overlaid and unworkable when frequency and receiver points are of the order of 100 or more. What is required is to be able to view the pressure at all receiver points and at all frequencies at once. This can be achieved with a 3D plot where the x axis represents frequency, the y axis receiver position index and the z axis pressure. Conceptually it is like stacking up all the frequency response plots along the y axis or indeed all the distance plots along the x axis. In this manner the result of any change is seen across the entire range of frequency and position. Such 3D plots are shown in the Figures, discussed below, for the performance of the speaker arrays of the invention.

EP 1 523 221 A2 discloses a system for setting up a domestic hi-fi system, in particular the sub woofers thereof. A sub woofer is placed in possible positions and the transfer function of the system is measured by sampling a test sound with a microphone at one or plural listening positions. The number of available transfer functions is increased by modifying the measured ones with ones for adding delay to the sound signal before it is reproduced by the sub woofer etc. Set-ups having more than one subwoofer are made by superposing the transfer functions. The system does not therefore model the propagation of the sound in the space but merely measures the output (i.e. the sound at the listening position) empirically. The system searches through the possible systems and ranks them by various aspects of their transfer function, allowing one to be chosen.

GB 2 259 426 A discloses another audio system whose performance is empirically measured. An array of speakers is used to produce constant directivity over a wide range of frequencies. The directivity functions between each speaker of the array and each of a number of positions equidistant from the array are measured and then compensating filter functions are calculated, which filter functions are used by digital filters respective to the speakers that modify the otherwise common sound signal before it is applied to the individual speakers.

US 2005/031135 A1 published 10 February 2005 discloses a system for configuring an audio system for a given space. The system may statistically analyze potential configurations of the audio system to configure the audio system. The potential configurations may include positions of the loudspeakers, numbers of loudspeakers, types of loudspeakers, listening positions, correction factors, or any combination thereof.

The statistical analysis may indicate at least one metric of the potential configuration including indicating consistency of predicted transfer functions, flatness of the predicted transfer functions, differences in overall sound pressure level from seat to seat for the predicted transfer functions, efficiency of the predicted transfer functions, or the output of predicted transfer functions. The system also provides a methodology for selecting loudspeaker locations, the number of loudspeakers, the types of loudspeakers, correction factors, listening positions, or a combination of these schemes in an audio system that has a single listening position or multiple listening positions.

US 5233664 A published 3 August 1993 discloses a speaker system including a common input terminal for receiving an audio signal to be acoustically radiated; several speaker units; several digital filters connected between the common input terminal and the speaker units, and a filter coefficient for each of the digital filters. The speaker units are arranged linearly, in a matrix form or in a honeycomb form.

Bill Webb et al, "Advances in line array technology for live sound", AES UK 18th Conference: Live Sound, published 1 April 2003, discusses possible reasons for the line array principle being applied to live sound and explains factors to be considered in implementing a practical design. In particular for array curvature the paper proposes to use a computer model that automatically optimises the curvature to suit a venue.

An article in the journal "The Edge", April 2005 by Martin Audio, describes a tool to predict the sound of line arrays and how it can be used in an iterative approach for sound system design. The tool determines all splay angles of an array automatically.

SUMMARY OF INVENTION

The present invention provides methods of configuring loudspeaker arrays and computer program products as defined in the appended claims.

BRIEF DESCRIPTION OF THE DRAWINGS

Examples of the invention will now be described with reference to the accompanying drawings, of which:

FIGURE 1      is a perspective view of a typical line array loudspeaker system;
FIGURE 2      is a side view of the mechanical mechanism for adjusting the splay angle between two line array elements;
FIGURE 3      is a cross section through a venue showing the points at which the pressure produced by the array of speakers is evaluated;
FIGURE 4      is a system block diagram of the computer system of the present invention;
FIGURE 5      shows the hemispherical polar performance of one element of the line arrays simulated in the examples of the invention;
FIGURE 6      shows the performance of a line array optimised using an optimisation in a second example;
FIGURE 7      shows the performance of a line array adjusted manually,
FIGURE 8      shows the performance of a line array optimised using an optimisation in a first example;
FIGURE 9      shows the performance of a line array optimised using the optimisation of the invention in a third example using an objective function comprising a leakage component;
FIGURE 10      shows the performance of a line array optimised using an optimisation in a fourth example using an objective function comprising a flatness component;
FIGURE 11      shows a speaker element cluster array optimised using the present invention;
FIGURE 12      shows an array of floor positioned speakers optimised using the present invention.

DESCRIPTION OF THE EXAMPLES

In the present invention a computer system is used to optimise the configuration of a speaker array.

Optimisation is a branch of mathematics which encompasses techniques that attempt to find the N parameters $\mathbf{x} \in \mathbb{R}^N$ that minimise an objective function $\varepsilon(\mathbf{x})$, optionally including constraints on the parameters. A simple classification between the techniques is whether the calculation method uses the gradient of the objective function in order to determine the direction of the search in parameter space. One such class of calculation method which does not is the 'generalised pattern search' described in an introductory manner in J.E. Dennis J. Virginia, Derivative-free pattern search methods for multidisciplinary problems, American Institute of Aeronautics and Astronautics, pages 922-932, 1994 and analysed further in C. Audet and J. Dennis, Analysis of generalized pattern searches, TR00-07 Department of Computational & Applied Mathematics, Rice University, Houston.

Method 1 pattern search can be viewed as an adaptive grid search over the search space where the grid or mesh M is defined by the mesh size, $\Delta \in \mathbb{R}_+$ and a set of directions $\mathbf{D} \subset \mathbb{R}^N$ whose positive linear combinations span $\mathbb{R}^N$. Candidates for evaluation of the objective function are determined by polling neighbouring points, after an initial optional search of the mesh using some other means. A typical sequence of steps taken by a pattern search method is shown in Method 1 below, which describes the method in structured English.

```
Method 1 pattern search
─────────────────────────────────────────────────────────
Require: x_k , Δ_k for k = 1
 1: while Stopping criteria not met do
 2:    SEARCH : Perform a global search from the search
       point anywhere on M_k either heuristically or with
       some knowledge of the model to decide candidates for
       evaluation
 3:    if improved mesh point found (ε(x_k+1) < ε(x_k)) then
 4:       Optionally increase the mesh size (Δ_k+1 ≥ Δ_k)
 5:       search point becomes this improved point
 6:       break
 7:    else
 8:       POLL : look at neighbouring points in the mesh
 9:       if improved mesh point found (ε(x_k+1) < ε(x_k)) then
10:          search point becomes this improved point
11:          break
12:       else
13:          Reduce mesh size (Δ_k+1 < Δ_k)  {This point is a mesh
             local optimiser}
14:          search point becomes this point
15:          break
16:       end if
17:    end if
18:    increment k
19: end while
─────────────────────────────────────────────────────────
```

Table 1

The method homes in on an optimal point by checking the neighbouring points of the current point to see if they are better and if not reducing the size of the mesh so that closer points can be found. The optional step of increasing the mesh size (step 4) is to help find other minima in the search space. The iterations can be stopped according to various criteria, for example, time or number of iterations, mesh size, relative change in the objective function or an absolute value of the objective function can all be used for the stopping criteria.

In a first example Method 1 is used to optimise the splay angles of a line array. (Other optimisation calculation methods may be used, however, whether they use the gradient of the objective function or otherwise.) Taking a particular vertical array of N identical uniformly excited elemental loudspeakers as an example these are characterised by a set of splay angles **x,** each being the angle between one element and the next. The line array is modelled as being, as a whole, at a fixed position in a venue, which in turn is defined by a set of audience $r_a$ and non-audience planes $r_{na}$.

The resultant complex sound pressure produced by the speaker array at the audience points is a matrix **P** having elements $[P]_{i,j} = P(r_a, f, x)$ where **x** is the set of the splay angles (a parameter) and **f** is a set of discrete frequencies $f_j$ and $r_a$ is a set of audience positions $r_i$. The positions are numbered with a position index i from 1 at the position nearest the speaker array increasing with distance to a maximum furthest from the speaker array. At each iteration k this matrix is calculated and then an objective function based $\varepsilon(P)$ on it is evaluated to see if a better configuration for the array has been found. The pressure function is evaluated at a set of discrete location points in the venue and for a discrete set of frequencies. This discretisation of the independent variables sets the level of fine detail that can be resolved. The spatial variable is defined at intervals in the region of 0.1m to 1.0m. Frequency is divided into 1/36th octave bands and is adequate for representing most frequency responses. The pressure function P is evaluated using a computer by using the directional point source model, as, of course, is done in the known CAD systems.

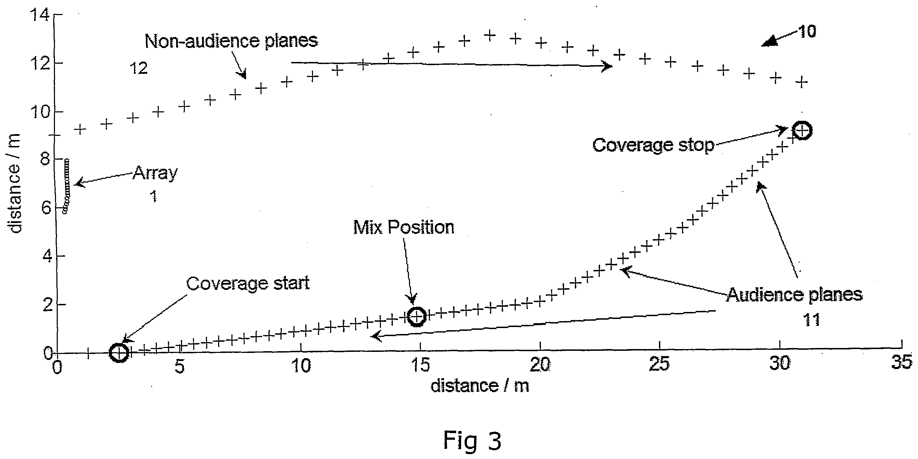

Figure 3 shows the set of points used in this example. Figure 3 shows cross section through a venue 10 with the line array 1 suspended at one end. A set of location points 11 is shown which are typical of where the audience would be on banked seating. Since this is a vertical 2D slice through the venue (in particular through the array elements and on the axis thereof) and since that is being taken as representative of the whole venue the points are termed "audience planes". Non-audience points or "planes" are defined at the ceiling of the venue or unused audience planes.

The optimisation method used expects an objective function that returns a single real positive number because that is simple to compare with the previous value to determine which is better. Below are given various examples for the objective function used. These objective functions would be suitable for use with the many other optimisation methods that exist. In terms of complex pressure amplitudes **P** at audience planes, it could, as a first example, be desired that the pressures have the same fixed magnitude everywhere at all frequencies. Our experience has demonstrated that uniform pressure amplitude at every position and frequency is not very useful target and it conflicts with an audiences' psychoacoustic expectations.

In a second example for the objective functions the target $P_{targ}(r_a, f)$ is defined as follows. $P_{targ}$ is defined only at audience positions and its value elsewhere is not taken into account in the objective function. A target shape for the pressure distribution on audience planes is set by choosing a 'mix' position $r_{mix}$ at some point away from the array on the audience planes section, and choosing sound levels, $\Delta P_{start}$ and $\Delta P_{stop}$, relative to the arbitrary pressure at $r_{mix}$ for positions at the extremes of the audience planes section. In between each extreme point and the mix position the target pressure has a constant gradient. The mix position is intended to be that at or for which the mixing engineer mixes the sounds being produced by the speaker array.

Typical values create a target that progressively drops in amplitude with increasing distance from the array. A flat frequency response at all positions is stipulated in the target $P_{targ}$ so that mixing engineers can globally adjust the spectrum to their liking.

The objective function for those two examples compares, at each point, the pressure produced by the speaker array as calculated with the target pressure and sums a measure indicative of those differences.

In a third example the objective function has in addition to the primary criterion of a target pressure, a measure that indicates the flatness of the frequency response at each audience position. For each point the mean pressure amplitude over frequency is determined; a flatter response is indicated by calculating a measure of how close the pressure values, at all frequencies at that position, are to the mean.

According to the invention, the objective function has, in addition to the primary criterion of a target pressure, a second measure that quantifies the "leakage field", defined as a measure indicative of the relative size (for example the ratio) of the total pressure delivered to the non-audience positions compared to the total pressure delivered to audience positions.

Measures of the partial derivatives with respect to frequency or position on our result surface could, as fifth and sixth examples for the objective functions, be minimised over frequency and position.

The objective function can also be a weighted combination of the examples given above for example a weighted average. The combined objective function $\varepsilon(x)$ is given in Equation 1 below, where the coefficients $c_n$ controls the relative importance of the various components.

$$\varepsilon(\mathbf{x}) = c_1 . \varepsilon_{targ} + c_2 . \varepsilon_{fresp} + c_3 . \varepsilon_{leak} + c_4 . \frac{\varepsilon_{\partial P}}{\partial r} + c_5 . \frac{\varepsilon_{\partial P}}{\partial f}$$

$$(Equation\ 1)$$

where $\varepsilon_{targ}$ is the measure of how closely the calculated sound field fits the target sound field, $\varepsilon_{fresp}$ is the measure of flatness of the frequency response, $\varepsilon_{leak}$ is the measure of leakage of the sound field to non-audience positions and $\frac{\varepsilon_{\partial P}}{\partial r}$ and $\frac{\varepsilon_{\partial P}}{\partial f}$ are the measures of the rate of change of the sound field with respect to distance and frequency respectively.

In detail, the components of the objective function are preferably calculated as follows.

$\varepsilon_{targ}$ is the sum over all the audience points and over all frequencies of a measure of the difference in magnitude between $P_{targ}$ and $P_a(\mathbf{r_a},\mathbf{f},\mathbf{x})$ calculated in accordance with the radiation model. $P_{targ}$ may be, for example, either of the functions noted above as objective function examples one and two. Example two (in particular using the target function involving $\mathbf{r}_{mix}$) is preferably calculated as follows.

$$mean_{rmix} = \frac{\sum_{k=1}^{k=N_f} [\mathbf{Pa}]_{j_{mix},k}}{N_f} \qquad \text{Equation 2}$$

$$\varepsilon_{targ} = \frac{\left\| mean_{rmix} + [\mathbf{Ptarg}] - [\mathbf{Pa}] \right\|_2}{\sqrt{N_a}} \qquad \text{Equation 3}$$

Evaluation of the target $P_{targ}(\mathbf{r_a},\mathbf{f})$ at each $N_a$ audience positions by $N_f$ frequencies produces an $N_a$ by $N_f$ matrix [Ptarg], where $N_a$ is the number of audience positions and $N_f$ is the number of frequency points. $j_{mix}$ is the position index of $\mathbf{r}_{mix}$. The mean$_{rmix}$ target component in $\varepsilon_{targ}$ given in Equation 3 allows the shape of the target function to 'float' slightly in level since it is the shape that is important rather than some absolute level. Each time a new speaker array configuration is calculated a value for the mean pressure amplitude across frequency is determined at $\mathbf{r}_{mix}$ in accordance with Equation 2; the target is then defined relative to this value. If the target was an absolute fixed value and was somewhat distant to the existing distribution then the optimiser would attempt to move the pressure closer to this - this results in significant and undesirable peaks developing since overall system gain is not a parameter available to the optimiser. This method can also be used to calculate the objective function for other target shapes $P_{targ}$ and not just the particular one mentioned above; for any such shape a mixing position $r_{mix}$ is chosen to allow the shape to float as described above.

$\varepsilon_{fresp}$ is a measure that indicates the flatness of the frequency response at each audience position and is preferably calculated as follows:

$$mean_j = \frac{\sum_{k=1}^{k=N_f} [\mathbf{Pa}]_{j,k}}{N_f} \qquad j = 1 \ldots N_a \qquad \text{Equation 4}$$

$$\varepsilon_{fresp} = \frac{\left\| [\mathbf{Pf}] - [\mathbf{Pa}] \right\|_2}{\sqrt{N_a}} \qquad \text{Equation 5}$$

where [**Pf**] is given by

$$[\mathbf{Pf}]_{j,k} = mean_j \quad k = 1 \ldots N_f, \ j = 1 \ldots N_a$$

Equation 6

For each audience point the mean pressure amplitude over frequency is calculated (Equation 4) resulting in a vector $mean_j$. This is expanded to a matrix of the same size as [**Pa**] Equation 6, which forms part of the component $\varepsilon_{fresp}$ given in Equation 5. This measure of flatness of the frequency response is therefore the distance of the calculated points from the mean response at a position.

$\varepsilon_{leak}$ is a measure of the relative size of the total pressure delivered to the non-audience planes to that delivered to the audience planes and is preferably calculated as follows

$$\varepsilon_{leak} = \frac{\sum_{j=1}^{j=N_{na}} \sum_{k=1}^{k=N_f} [\mathbf{Pna}]_{j,k}}{\sum_{j=1}^{j=N_a} \sum_{k=1}^{k=N_f} [\mathbf{Pa}]_{j,k}}$$

Equation 7

where **Pna** is the pressure matrix for the non-audience positions.

The components $\varepsilon_{\frac{\partial P}{\partial r}}$ and $\varepsilon_{\frac{\partial P}{\partial f}}$ are the totals over all audience positions of the numerical partial derivatives of **P(r,f,x)** calculated in accordance with the radiation model with respect to distance and frequency respectively. Preferably they are calculated as follows:

$$\varepsilon_{\frac{\partial P}{\partial f}} = \frac{\left\| \frac{\partial P(\mathbf{r}_a, \mathbf{f})}{\partial f} \right\|_2}{N_a}$$

$$\varepsilon_{\frac{\partial P}{\partial r}} = \frac{\left\| \frac{\partial P(\mathbf{r}_a, \mathbf{f})}{\partial r} \right\|_2}{N_a}$$

Equations 8 and 9

The coefficients $c_1$ to $c_5$ of Equation 1 can be adjusted by the user to trade off between different objectives, for example sacrificing how well the pressure meets a target function against how much pressure leaks from the audience planes section and may be zero.

In the above equations the norms (indicated by the double vertical bar pairs) are calculated according to the following (with p=2):

$$\|A\|_p = \left( \sum_{i=1}^{m} \sum_{j=1}^{n} |a_{ij}|^p \right)^{1/p}$$

Equation 10

For the optimisation iteration a starting point for the candidate parameter set is required. Generally this is not critical but a configuration in which each part of the audience is covered by the output of an element (which are directional) is likely to be in the region of the output of the optimisation and so makes a reasonable starting point since the optimisation process will take less time on the computer. Preferably at least the top box should be orientated towards the most distant audience position. The user can choose this or select a starting point of their own.

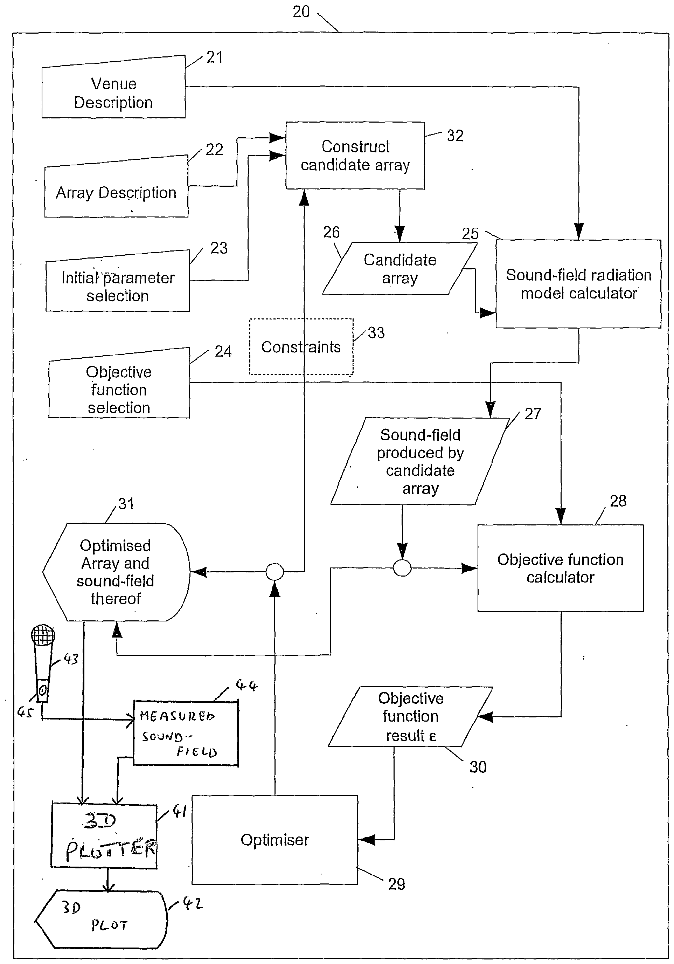

Figure 4 is a system diagram showing the components of the software system used to perform the optimisation. The software is run on a standard personal computer 20. It comprises input modules 21, 22, 23, 24 that allow the user to input respectively a description of the venue (i.e. the information in Figure 1 concerning the audience positions and the non-audience positions), a definition 22 of the array (including the positions of the element speakers, and their acoustic properties for use in the radiation model), a selection 23 of the parameters (e.g. splay angles) to be used as the first candidate, and a selection 24 of the objective function to be used in the optimisation (e.g. a selection of weights $c_1$ to $c_5$). The optimisation loop proceeds as follows. A sound radiation field calculator 25 takes as its input the venue description 21 and a candidate array description 26 (which includes the properties 22 of the array elements and the selected parameters 23 for the candidate array) and produces from that the simulated sound field 27 that would be produced by the array. An objective function calculator 28 uses the sound field and the selected 24 objective function to evaluate the objective function. An optimiser 29 uses the result 30 of that to see if the candidate array is better than the previous one and to construct 32 a new candidate 26, unless the optimiser decides that the optimised parameter set has now been found. The optimiser may use any of many available optimisation methods available, including Method 1 that was described above. Once the optimised parameter set 31 has been found it is provided to an output module, which displays it to the user together with the sound field 31 calculated for the speaker array as defined by the parameter set, the latter both for interest and user confirmation that a sensible result has been found.

Once the optimised parameters have been found (e.g. splay angles for a line array) have been determined by the optimisation calculation the user adjusts the physical array 1 in accordance with those parameters).

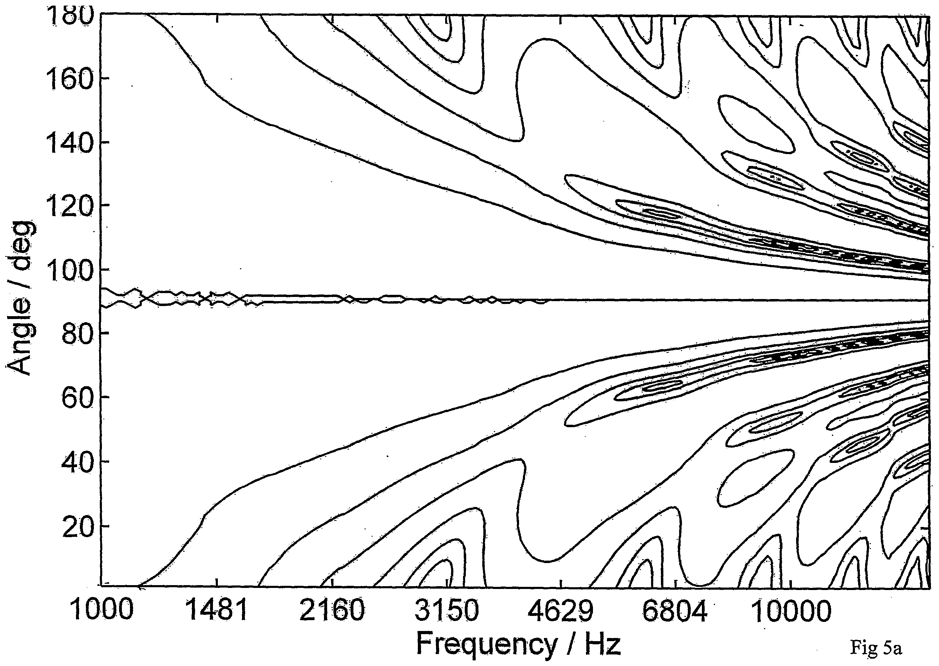

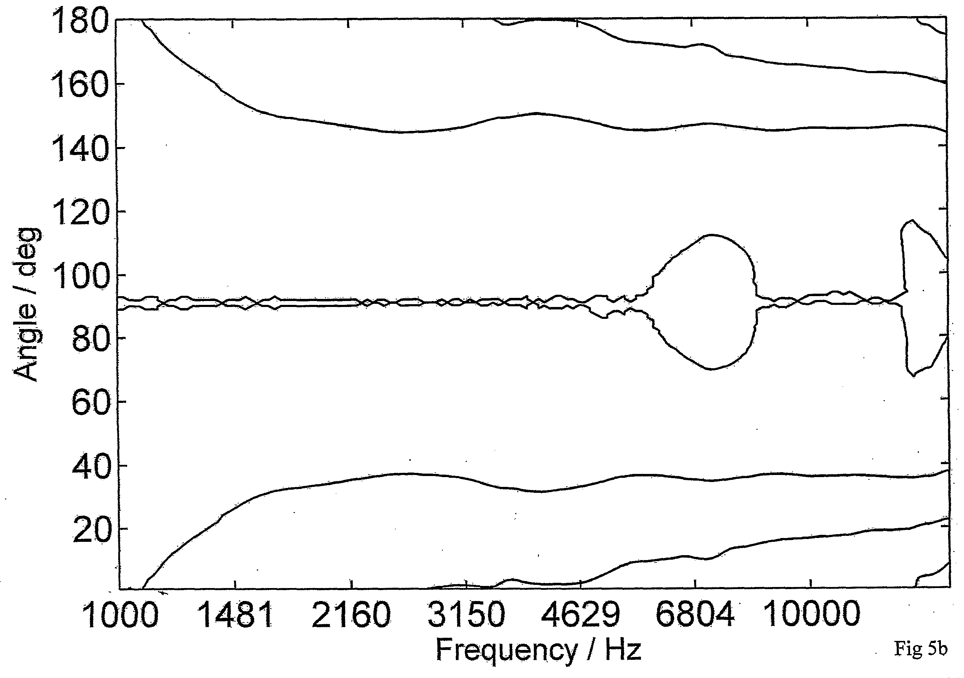

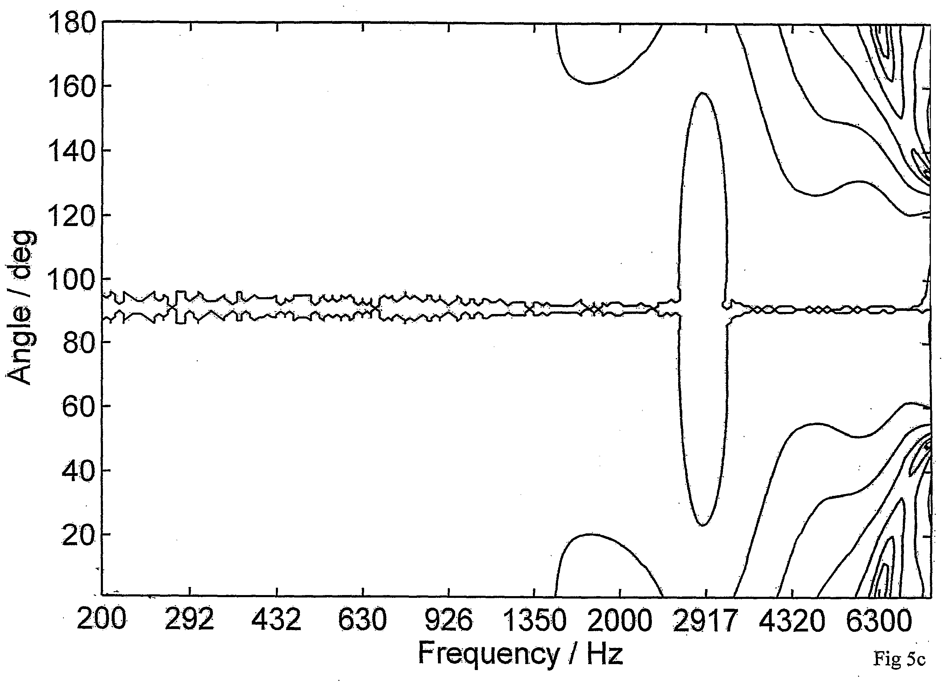

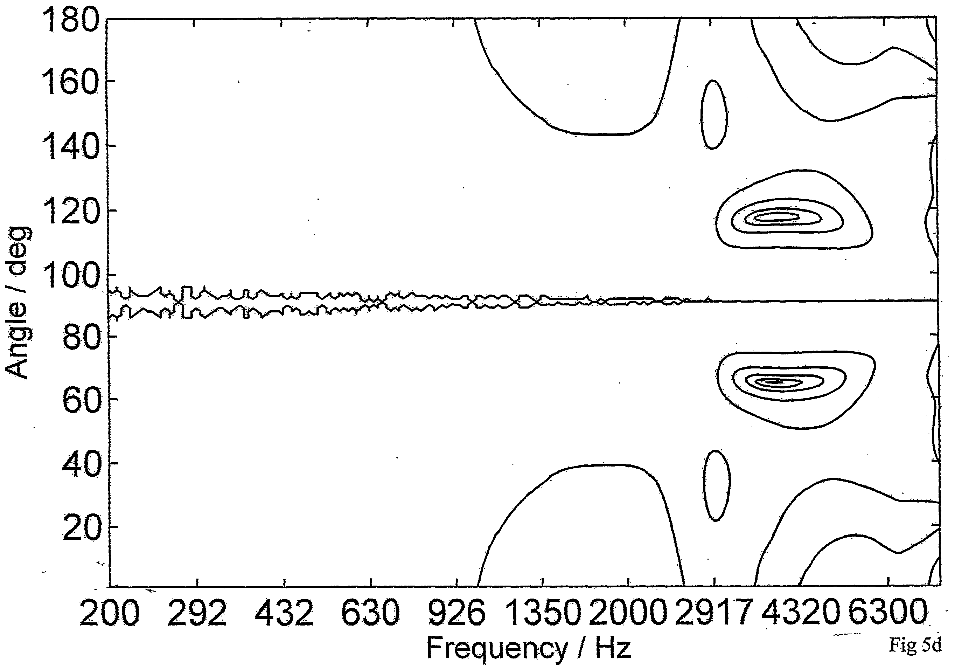

In a second example the speaker array is optimised using a constraint on the parameters, in this instance the splay angles. In this example the generalised pattern search (i.e. Method 1 above) is again applied to the splay angles parameters for a uniformly driven array in an example venue, again as shown in Figure 1. The objective function is taken as equation 1 above with $c_1 = 1$ and $c_i = 0$ for $i = 2$ to 5 and $P_{targ}(\mathbf{r}_a, \mathbf{f})$ being based on the mixing position as described above with values for $\Delta P_{start}$ and $\Delta P_{stop}$ of +6dB and -6dB respectively. An example array on which this example was performed comprises of 20 identical elements 115mm high each containing an HF and LF section in close proximity; polar performance for a single element is shown in Figure 5 in which each contour is a 3dB change. The maximum splay between elements is 6 deg and the minimum is 0 deg with 0.5 deg steps available in this range. The constraint used in this example is a progressive curvature of the array. This is achieved by splitting the array into 7 sections, one for each major division of the splay angle range. All the elements of a section have the same splay angle, starting at 0 and ending at 6 in the last section. The array is defined by the number of elements in each section, which are then the parameters optimised. The computer system used is the same as in Figure 4 but the optimiser uses as the parameters to be adjusted the set of the number of elements in each section, rather than the splay angles directly. Once the optimiser has selected a new candidate the parameter set is turned into a set of splay angles for each of the elements and the simulated sound field is calculated as before. Note it is allowed to have zero elements in a section.

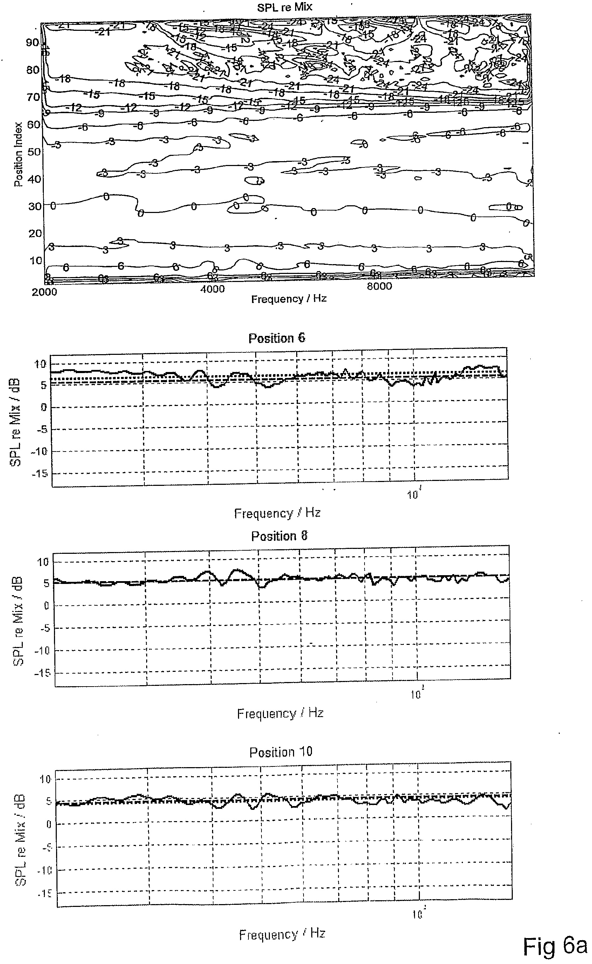

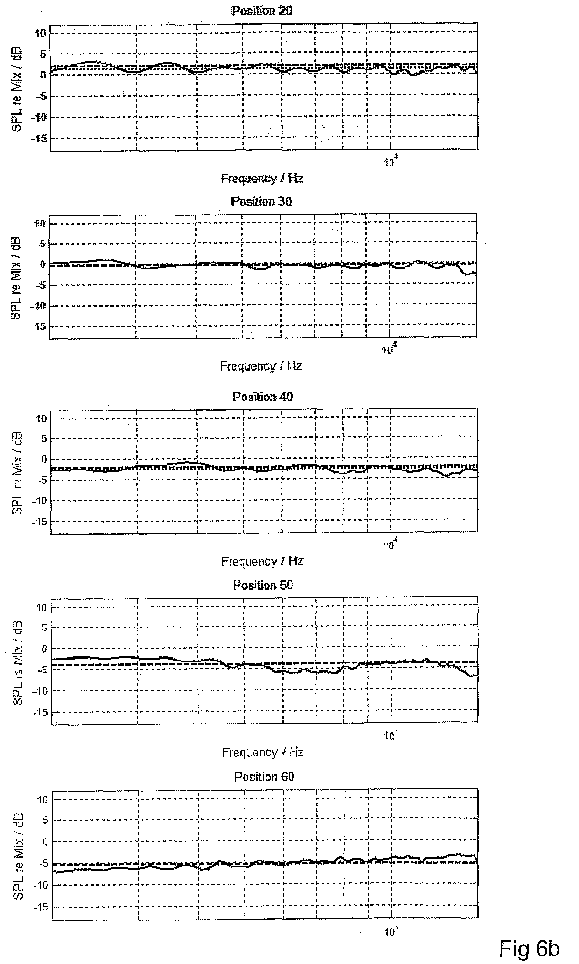

Displayed in Figure 6 is the sound field generated in this constrained example. This shows a 3D contour plot of the sound pressure level against position and frequency and below that several graphs of the sound pressure against frequency at selected ones of the audience positions. On those graphs the long dashed level is the target level and the dotted level is the average level achieved, which ideally should be the same.

The pattern search algorithm took just under 70s to perform the 7 iterations in which 81 function evaluations were performed. The routine was halted when a minimum mesh size had been reached; other runs allowing smaller meshes did not result in significantly better solutions.

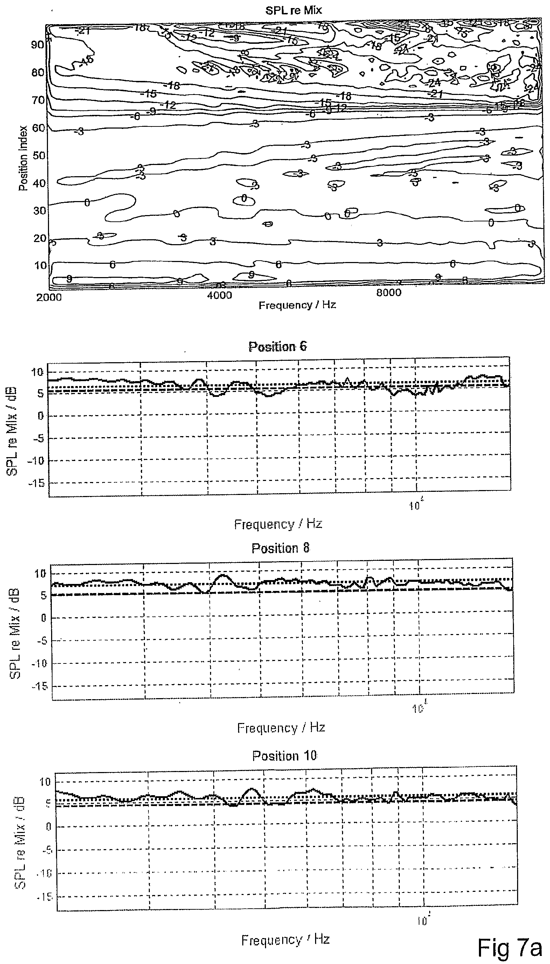

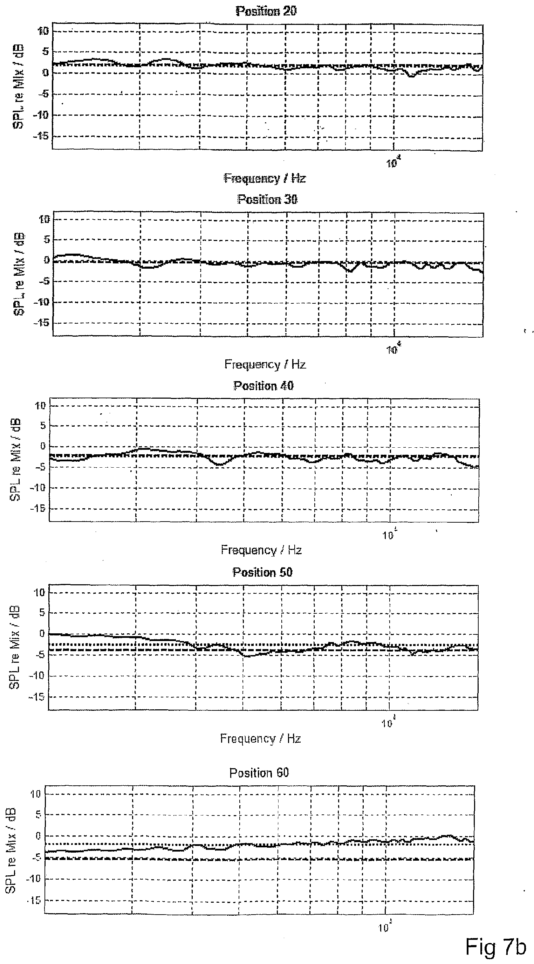

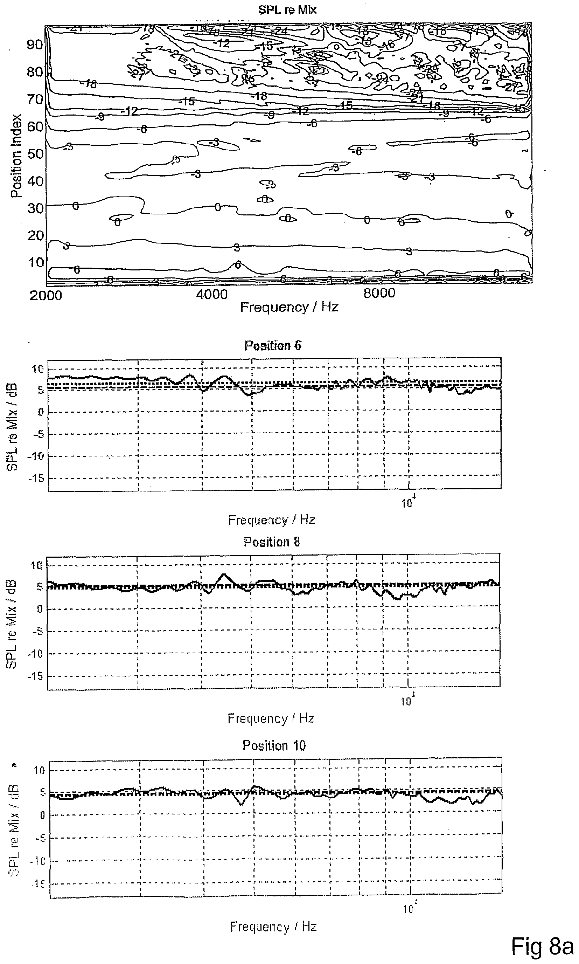

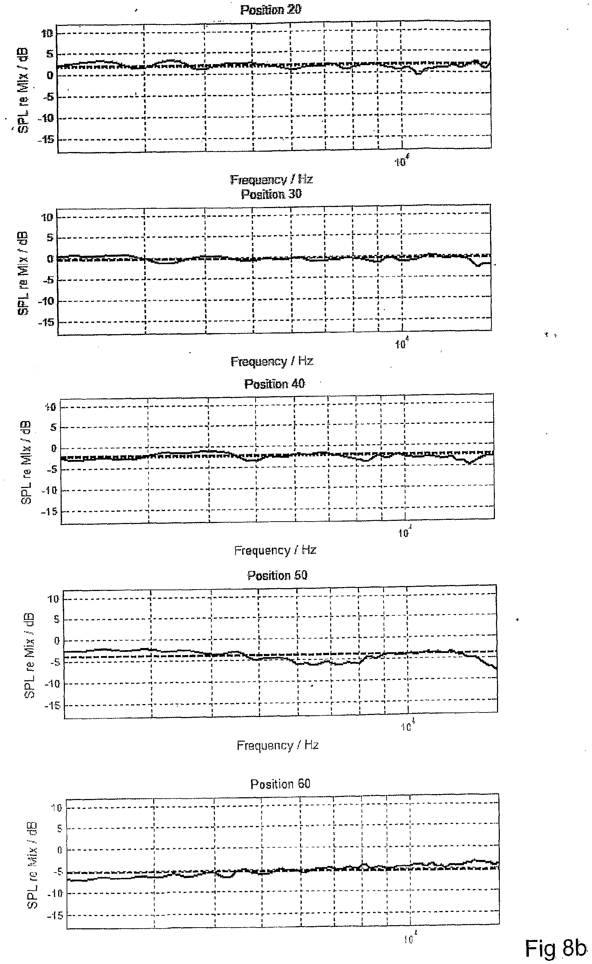

For comparison a set of splay angles was determined manually (i.e. using a prior art CAD system that calculates just the sound field for a user chosen set of splay angle) in an effort to achieve a particular target and the results are shown in Figure 7 (in a similar manner to Figure 6). Figure 8 shows the results for the unconstrained computer optimisation of the first example above. The manual attempt was fairly lacklustre at fulfilling the target; it very nearly has the same number of elements in each section. The constrained computer optimisation appears better in that it meets the desired pressure distribution shape as dictated by $P_{targ}$. (The starting point splay angles for constrained computer optimisation and the manual procedure were the same.)

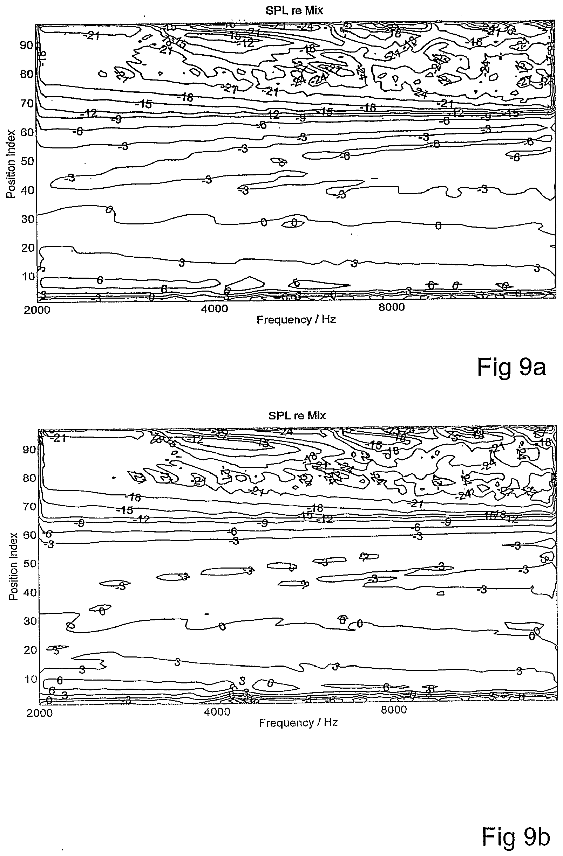

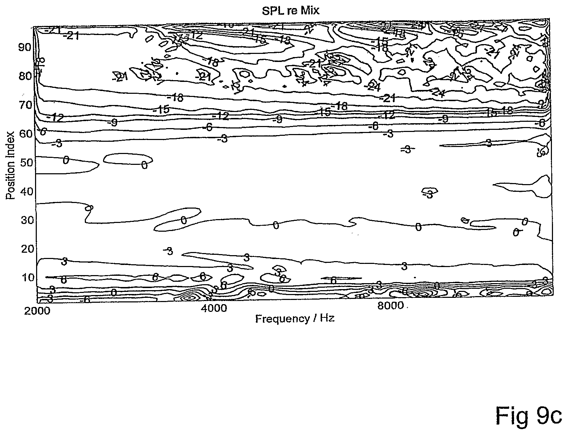

As a third example and according to the invention, the effect of including $\varepsilon_{leak}$ as well as $\varepsilon_{targ}$ is shown in Figure 9, which has three 3D plots with increasing values of $c_3$ for the leakage component. As more account is taken of the leakage the sound concentrates at the central audience positions.

Similar results were obtained for the first unconstrained example above. Figure 8 shows this array performance for that example. The routine used a mesh size and time limit stopping criteria. After 20 mins and over 800 function evaluations the routine was stopped. Other runs allowing more time produced little further improvement before being stopped by the mesh size criteria.

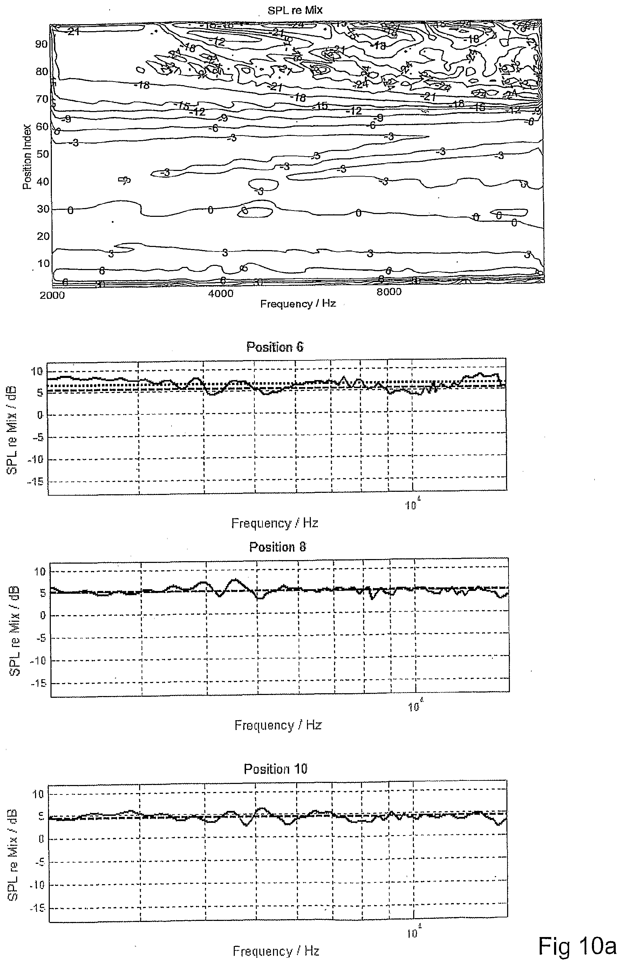

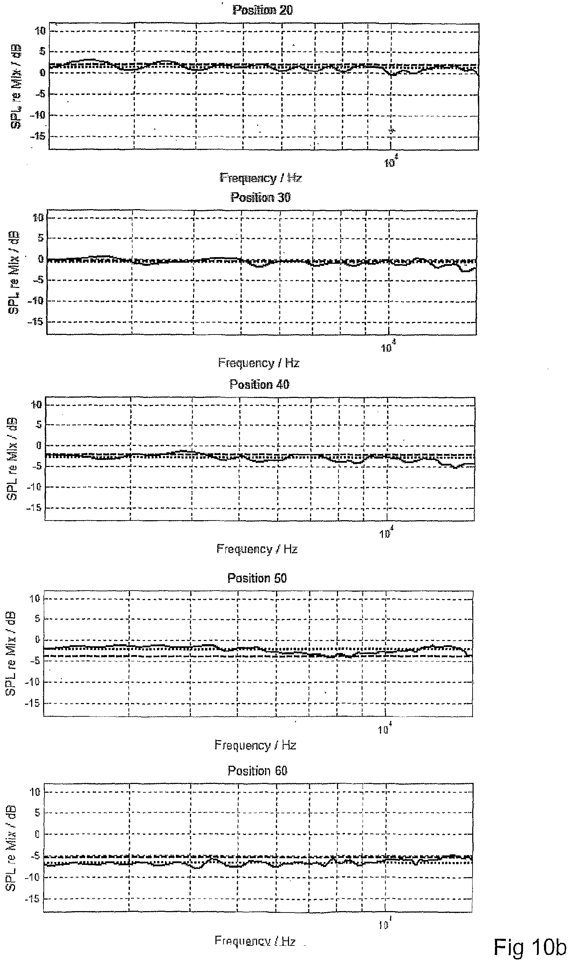

For a fourth example Figure 10 shows the effect of including $\varepsilon_{fresp}$ in addition to $\varepsilon_{targ}$. The frequency responses for this example are noticeably flatter than for the other examples and at a little expense of being less close to the target.

Note that in the examples above changing the splay angles of the line array elements affects their position, since the more curved the array becomes the further back the lower elements move with respect to the audience positions. The optimisation takes this into account by calculating the new positions of the elements each time the splay angles are changed. These new positions are taken into account by the sound field calculation for the new array configuration.

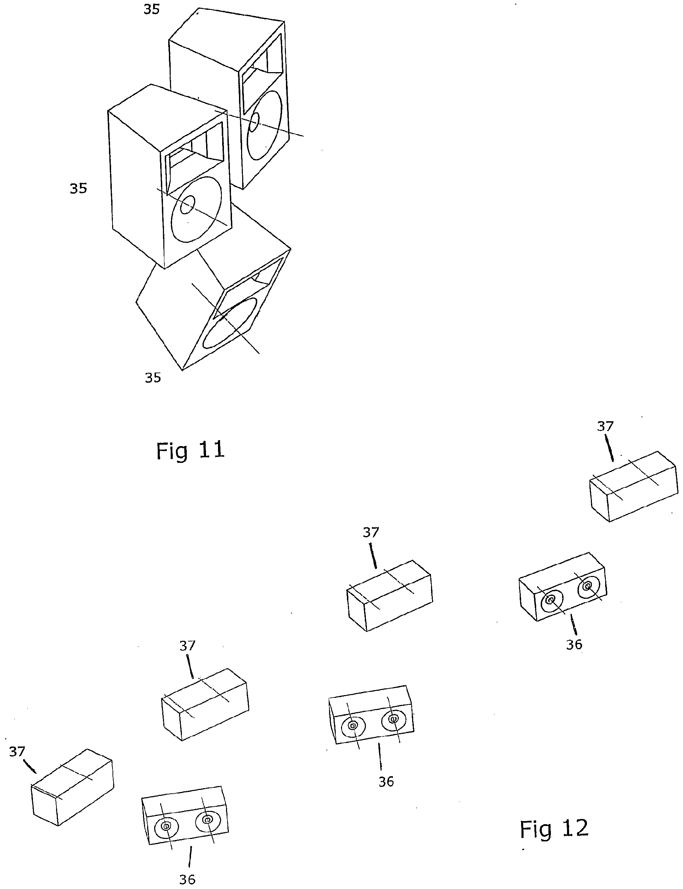

In a fifth example of the invention the optimisation is applied to further parameters of the array of speakers 35, in particular to the position of the elements. Figure 11 shows another speaker array in which both the orientation and the position of the individual elements can be adjusted by the user. Here three speakers are mounted in a cluster on traditional "yokes" or "flying frames" (not shown) which allow their orientations to be adjusted. The computer optimisation method of the invention is used to optimise their orientations. Here the individual speakers are not all pointing to audience positions in the same vertical plane and so they deliver significant sound levels . (Compare the line array examples above.) To cope with that the optimisation uses audience and non audience positions in vertical planes, one for each of the speakers in the cluster, that contain the axis of their respective speaker in its initial pre optimisation position. The orientations of each speaker both in the horizontal and vertical directions are made parameters of the optimisation. The sound pressure at each audience and no-audience position is calculated from the contributions made by all of the speakers. The objective function, for example, one of those from the examples above, is then calculated across all the points (audience or non-audience as appropriate) on all of the vertical planes. This may be a more lengthy calculation than for a single vertical plane but is more efficient than covering the whole of the venue space with calculation points.

In a sixth example of the invention the speaker array is as shown in Figure 12. In this a plurality of low frequency speakers 36 and 37 are placed on the floor or stage of the venue. The speaker units can be easily moved in position or orientation about the vertical axis by moving about the floor or stage. Those variables are further parameters of the optimisation in this example. Other parameters used in this example are the phase (i.e. polarity) of the signal applied to the unit (which is usually achieved in the controller that supplies the signals to speaker units), and the gain and delay applied to the signal applied to each speaker unit. Although orientation is one of the parameters of the optimisation, because low frequency units are not very directional the orientation has only a small effect on the sound field; the parameter of position has a greater effect. Delay and phase have similar effects to position and are included because there can be constraints on the positioning of the speakers, for example the speaker units may be limited to certain areas on the venue floor or stage. As with the other examples above the system allows constraints on these parameters to be applied during the optimisation process. The optimisation for this array uses preferably audience and non-audience points on a centre line though the venue from the array to the furthest audience points. It nonetheless allows the user to specify additional planes but this increases the computation time. However since at low frequencies the grid on which the sound field is simulated can be 2-3m in pitch it is feasible to calculate the sound field for all audience positions in a venue (i.e. not just limited to those on selected plane(s)). Figure 12 shows some 37 of the units being rearward facing.

These act to cancel parts of the sound field produced by the array. Nonetheless these units are treated in the same way as the others in the optimisation and can arise from it (as long as no constraint on the orientation of the units prevents this.)

All the examples above have had orientation of the speaker elements as one of the adjustable parameters. It would nonetheless be possible for the invention to use just, for example, the positions of the speakers, if for example the orientation could not be adjusted. Or given that low frequency speakers are not very directional in the sixth example above orientation could be omitted without the result being degraded too much for some applications.

In the cases above where the sound field calculation involves speaker elements not on one of the vertical planes containing the audience points the sound field calculation simply takes into the actual distance between the element and the point of interest; in such cases, howver, the balloon of points surrounding the element used in the sound model becomes 3-dimensional rather than 2-dimensional. Indeed the points of interest taken into account in the objective function need not be confined to the vertical planes of the examples; interesting points from all over the 3-dimensional volume (for example all audience points) could be taken into account. The number of points used, should preferably not be so great as to make the optimisation calculation take so long as to be inconvenient to the user.

As noted above, the 3D plot is a useful item. The computer 20 is preferably provided with a 3D plotter 41 to produce the 3D plot 42. This displays the 3D plot either on the monitor of the computer or sends it to a printer to be printed. The 3D plotter 41 plots the sound pressure level on one axis, against position and frequency on the other two axes. As shown in the Figures attached hereto, the 3D plot may be rendered in two dimensions having axes of positions and frequency, with the sound pressure level being indicated by contours and/or level shading or colours.

The 3D plotter 41 may also be provided as a stand-alone device, independent of the speaker array optimiser provided by personal computer 20. As an independent device, the plotter is connected to a sound pressure measuring device 43, for example a microphone, to receive measurements of the sound field. Alternatively a plurality of microphones at different positions may be used.

If a single microphone is used then this is moved from position to position to receive test sounds. These, of course, may be generated by a speaker array as previously herein described but, of course, other sources may well be of interest.

The positions for each measurement can either be keyed in by hand or can be recorded by an automatic position measuring device 45.

**Claims**

1.   A method of configuring an array (1) of speaker elements for use in a venue (10), comprising

> (a) providing an initial candidate configuration (23) for the array (1) and iterating, until a stopping criteria is reached, the steps of:
>
>> (i) computing, with a computer (20) and using a radiation model, a sound field (27) produced by the array (1) having the candidate configuration at a plurality of points in venue (10), and
>> (ii) evaluating, with a computer (20) a result of an objective function (24) involving the calculated sound field (27) at a plurality of audience positions in the venue (10),
>> (iii) constructing, with a computer (20) a new candidate configuration (26) for the array (1) using the result of the objective function (24),
>
> and (b) configuring the array (1) in accordance with a preferred candidate configuration (31) of the array (1) produced by the iterations, wherein the preferred candidate configuration (31) is selected, with a computer (20), using the results from evaluating the objective function (24), wherein the objective function (24) comprises a sum over a plurality of audience positions of a measure indicative of the difference between the magnitude of the sound field (27) and a target value for the magnitude of the sound field (27) at those positions, and further comprises a measure indicative of the relative size of the total pressure delivered to non-audience positions compared to the total pressure delivered to audience positions.

2.   A method as claimed in claim 1 wherein the target value at each audience position is taken to be relative to a mean value, at each iteration, of the magnitude of the sound field (27) over a set of frequencies at that audience position.

3.   A method as claimed in claim 1 or claim 2, wherein a target is defined at a first audience position and that for other positions is interpolated from that to respective target values at audience positions at a distance from that first audience position.

4.   A method as claimed in any preceding claim wherein the objective function (24) comprises a sum over a plurality of audience positions of a measure indicative of a rate of change of the magnitude of the sound field (27) with respect to frequency.

5.   A method as claimed in any preceding claim wherein the objective function (24) comprises a sum over a plurality of audience positions of a measure indicative of a rate of change of the sound field (27) with respect to position.

6.   A method as claimed in any preceding claim wherein the objective function (24) comprises a measure of flatness of the frequency response over a set of audience positions.

7.   A method as claimed in claim 6 wherein the measure of flatness is a measure of how close the magnitude of the sound field (27) is, for a set of frequencies, to a mean value for the magnitude of the sound field (27) at each audience point.

8.   A method as claimed in any preceding claim wherein the magnitude of the sound field (27) is in terms of sound pressure level.

9. A method as claimed in any preceding claim wherein the selection of a new candidate configuration (26) is subject to a constraint.

10. A method as claimed in any preceding claim wherein the candidate configuration (26) of the array (1) is parameterised in terms of orientation of the elements of the array (1).

11. A method as claimed in any preceding claim wherein the candidate configuration (26) of the array (1) is parameterised in terms of position in the venue (10) of the elements of the array (1).

12. A method as claimed in any preceding claim wherein the candidate configuration (26) of the array (1) is parameterised in terms of polarity of a connection of the sound signal applied to elements of the array (1).

13. A method as claimed in any preceding claim wherein the candidate configuration (26) of the array (1) is parameterised in terms of gain applied to the sound signal applied to position in the venue (10) of the elements of the array (1).

14. A method as claimed in any preceding claim wherein the candidate configuration (26) of the array (1) is parameterised in terms of delay applied to the sound signal applied to position in the venue (10) of the elements of the array (1).

15. A method as claimed in any preceding claim wherein the array (1) is a line array comprising a plurality of linked speaker elements, angles between which can be adjusted.

16. A method as claimed in claim 15 wherein the candidate configuration (26) determines the angles between the elements and the values for the angles are constrained so that in one direction along the array (1) the angle between each element and the next element is the same or larger than the angle between that element and the previous element.

17. A method as claimed in claim 15 wherein the candidate configuration (26) determines the angles between the elements and the values for the angles can, independently of each other, adopt values between two limit values.

18. A computer program product that is arranged, when the program is executed by a computer, to perform the steps of the method of any preceding claim.

**Patentansprüche**

1. Verfahren zum Konfigurieren einer Anordnung (1) von Lautsprecherelementen zur Verwendung an einem Veranstaltungsort (10), umfassend:

(a) Bereitstellen einer anfänglichen Kandidatenkonfiguration (23) für die Anordnung (1) und Iterieren der folgenden Schritte, bis ein Anhaltekriterium erreicht ist:

(i) Berechnen eines Schallfeldes (27), das durch die Anordnung (1), die die Kandidatenkonfiguration besitzt, an einer Vielzahl von Punkten am Veranstaltungsort (10) erzeugt wird, mit einem Computer (20) und unter Verwendung eines Abstrahlungsmodells,
(ii) Auswerten eines Ergebnisses einer Zielfunktion (24), die das berechnete Schallfeld (27) an einer Vielzahl von Publikumspositionen am Veranstaltungsort (10) einbezieht, mit einem Computer (20), und
(iii) Konstruieren einer neuen Kandidatenkonfiguration (26) für die Anordnung (1) mit einem Computer (20) unter Verwendung des Ergebnisses der Zielfunktion (24) und

(b) Konfigurieren der Anordnung (1) gemäß einer bevorzugten Kandidatenkonfiguration (31) der Anordnung (1), die durch die Iterationen erzeugt wird, wobei die bevorzugte Kandidatenkonfiguration (31) mit einem Computer (20) unter Verwendung der Ergebnisse aus der Auswertung der Zielfunktion (24) gewählt wird, wobei die Zielfunktion (24) eine Summe einer Vielzahl von Publikumspositionen einer Maßnahme umfasst, die die Differenz zwischen der Größe des Schallfeldes (27) und einem Zielwert für die Größe des Schallfeldes (27) an diesen Positionen angibt, und ferner eine Maßnahme umfasst, die die relative Stärke des Gesamtdrucks, der an Nicht-Publikumspositionen abgegeben wird, im Vergleich zum Gesamtdruck, der an Publikumspositionen abgegeben wird, angibt.

2. Verfahren nach Anspruch 1, wobei der Zielwert an jeder Publikumsposition bezogen auf einen Mittelwert der Größe des Schallfeldes (27) bei jeder Iteration über eine Reihe von Frequenzen an dieser Publikumsposition angenommen wird.

3. Verfahren nach Anspruch 1 oder Anspruch 2, wobei eine Zielvorgabe an einer ersten Publikumsposition festgelegt ist und diese für weitere Positionen von dieser zu entsprechenden Zielwerten an Publikumspositionen in einem Abstand von dieser ersten Publikumsposition interpoliert wird.

4. Verfahren nach einem der vorhergehenden Ansprüche, wobei die Zielfunktion (24) eine Summe einer Vielzahl von Publikumspositionen einer Maßnahme umfasst, die eine Veränderung der Größe des Schallfeldes (27) in Bezug auf die Frequenz angibt.

5. Verfahren nach einem der vorhergehenden Ansprüche, wobei die Zielfunktion (24) eine Summe einer Vielzahl von Publikumspositionen einer Maßnahme umfasst, die eine Veränderung des Schallfeldes (27) in Bezug auf die Position angibt.

6. Verfahren nach einem der vorhergehenden Ansprüche, wobei die Zielfunktion (24) eine Maßnahme der Flachheit des Frequenzgangs über eine Gruppe von Publikumspositionen umfasst.

7. Verfahren nach Anspruch 6, wobei die Maßnahme der Flachheit eine Maßnahme davon ist, wie nahe der Betrag des Schallfeldes (27) für eine Reihe von Frequenzen an einem Mittelwert für die Größe des Schallfeldes (27) an jedem Publikumspunkt liegt.

8. Verfahren nach einem der vorhergehenden Ansprüche, wobei die Größe des Schallfeldes (27) in Form des Schalldruckpegels vorliegt.

9. Verfahren nach einem der vorhergehenden Ansprüche, wobei die Wahl einer neuen Kandidatenkonfiguration (26) einer Bedingung unterliegt.

10. Verfahren nach einem der vorhergehenden Ansprüche, wobei die Kandidatenkonfiguration (26) der Anordnung (1) in Form der Ausrichtung der Elemente der Anordnung (1) parametriert wird.

11. Verfahren nach einem der vorhergehenden Ansprüche, wobei die Kandidatenkonfiguration (26) der Anordnung (1) in Form der Position der Elemente der Anordnung (1) am Veranstaltungsort (10) parametriert wird.

12. Verfahren nach einem der vorhergehenden Ansprüche, wobei die Kandidatenkonfiguration (26) der Anordnung (1) in Form der Polarität eines Anschlusses des akustischen Signals, das an die Elemente der Anordnung (1) angelegt wird, parametriert wird.

13. Verfahren nach einem der vorhergehenden Ansprüche, wobei die Kandidatenkonfiguration (26) der Anordnung (1) in Form der Verstärkung parametriert wird, die an das akustische Signal angelegt wird, das an die Position der Elemente der Anordnung (1) am Veranstaltungsort (10) angelegt wird.

14. Verfahren nach einem der vorhergehenden Ansprüche, wobei die Kandidatenkonfiguration (26) der Anordnung (1) in Form der Verzögerung parametriert wird, die an das akustische Signal angelegt wird, das an die Position der Elemente der Anordnung (1) am Veranstaltungsort (10) angelegt wird.

15. Verfahren nach einem der vorhergehenden Ansprüche, wobei die Anordnung (1) eine Line Array ist, die eine Vielzahl von verknüpften Lautsprecherelementen umfasst, zwischen denen die Winkel einstellbar sind.

16. Verfahren nach Anspruch 15, wobei die Kandidatenkonfiguration (26) die Winkel zwischen den Elementen bestimmt und die Werte der Winkel derart eingeschränkt sind, dass der Winkel in einer Richtung der Anordnung (1) zwischen jedem Element und dem nächsten Element der gleiche oder größer als der Winkel zwischen diesem Element und dem vorhergehenden Element ist.

17. Verfahren nach Anspruch 15, wobei die Kandidatenkonfiguration (26) die Winkel zwischen den Elementen bestimmt und die Werte der Winkel unabhängig voneinander Werte zwischen zwei Grenzwerten annehmen können.

**18.** Computerprogrammprodukt, das ausgelegt ist, dann, wenn das Programm durch einen Computer ausgeführt wird, die Schritte des Verfahrens nach einem der vorhergehenden Ansprüche durchzuführen.

**Revendications**

**1.** Procédé de configuration d'un réseau (1) d'éléments haut-parleurs destinés à une utilisation dans un lieu de rencontre (10), comprenant les étapes suivantes

(a) fournir une première configuration candidate (23) du réseau (1) et itérer, jusqu'à ce que des critères d'arrêt soient atteints, les étapes suivantes :

(i) calculer, avec un ordinateur (20) et en utilisant un modèle de rayonnement, un champ acoustique (27) produit par le réseau (1) présentant la configuration candidate au niveau d'une pluralité de points du lieu de rencontre (10), et
(ii) évaluer, avec un ordinateur (20), un résultat d'une fonction objective (24) impliquant le champ acoustique calculé (27) au niveau d'une pluralité de positions d'écoute dans le lieu de rencontre (10),
(iii) construire, avec un ordinateur (20) une nouvelle configuration candidate (26) du réseau (1) en utilisant le résultat de la fonction objective (24), et

(b) configurer le réseau (1) selon une configuration candidate préférée (31) du réseau (1) produite par les itérations, où la configuration candidate préférée (31) est sélectionnée, avec un ordinateur (20), en utilisant les résultats de l'évaluation de la fonction objective (24), où la fonction objective (24) comprend une somme d'une pluralité de positions d'écoute d'une mesure indicative de la différence entre la grandeur du champ acoustique (27), et une valeur cible de la grandeur du champ acoustique (27) à ces positions, et comprend en outre une mesure indicative de la grandeur relative de la pression totale fournie à des positions de non écoute, comparée à la pression totale fournie aux positions d'écoute.

**2.** Procédé selon la revendication 1, où la valeur cible à chaque position d'écoute est prise par rapport à une valeur moyenne, à chaque itération, de la grandeur du champ acoustique (27) sur un ensemble de fréquences à cette position d'écoute.

**3.** Procédé selon la revendication 1 ou la revendication 2, où une cible est définie à une première position d'écoute, et celle des autres positions est interpolée à partir de celle par rapport aux valeurs cibles respectives aux positions d'écoute à une distance à partir de cette première position d'écoute.

**4.** Procédé selon l'une quelconque des revendications précédentes, où la fonction objective (24) comprend une somme d'une pluralité de positions d'écoute d'une mesure indicative d'une vitesse de changement de la grandeur du champ acoustique (27) par rapport à la fréquence.

**5.** Procédé selon l'une quelconque des revendications précédentes, où la fonction objective (24) comprend une somme d'une pluralité de positions d'écoute d'une mesure indicative d'une vitesse de changement du champ acoustique (27) par rapport à la position.

**6.** Procédé selon l'une quelconque des revendications précédentes, où la fonction objective (24) comprend une mesure de la planéité de la réponse en fréquence sur un ensemble de positions d'écoute.

**7.** Procédé selon la revendication 6, où la mesure de la planéité est une mesure de la proximité de la grandeur du champ acoustique (27), pour un ensemble de fréquences, par rapport à la valeur moyenne de la grandeur du champ acoustique (27) à chaque point d'écoute.

**8.** Procédé selon l'une quelconque des revendications précédentes, où la grandeur du champ acoustique (27) est exprimée en termes de niveau de pression acoustique.

**9.** Procédé selon l'une quelconque des revendications précédentes, où la sélection d'une nouvelle configuration candidate (26) est soumise à une contrainte.

**10.** Procédé selon l'une quelconque des revendications précédentes, où la configuration candidate (26) du réseau (1) est paramétrée en termes d'orientation des éléments du réseau (1).

**11.** Procédé selon l'une quelconque des revendications précédentes, où la configuration candidate (26) du réseau (1) est paramétrée en termes de position dans le lieu de rencontre (10)des éléments du réseau (1).

**12.** Procédé selon l'une quelconque des revendications précédentes, où la configuration candidate (26) du réseau (1) est paramétrée en termes de polarité de connexion du signal acoustique appliqué aux éléments du réseau (1).

**13.** Procédé selon l'une quelconque des revendications précédentes, où la configuration candidate (26) du réseau (1) est paramétrée en termes de gain appliqué au signal acoustique appliqué à une position dans le lieu de rencontre (10)des éléments du réseau (1).

**14.** Procédé selon l'une quelconque des revendications précédentes, où la configuration candidate (26) du réseau (1) est paramétrée en termes de retard appliqué au signal acoustique appliqué à une position dans le lieu de rencontre (10)des éléments du réseau (1).

**15.** Procédé selon l'une quelconque des revendications précédentes, où le réseau (1) est un réseau linéaire comprenant une pluralité d'éléments haut-parleurs reliés, dont les angles entre ceux-ci, peuvent être réglés.

**16.** Procédé selon la revendication 15, où la configuration candidate (26) détermine les angles entre les éléments, et les valeurs des angles sont imposées de sorte que, dans une direction le long du réseau (1), l'angle entre chaque élément et l'élément suivant soit identique ou supérieur à l'angle entre cet élément et l'élément précédent.

**17.** Procédé selon la revendication 15, où la configuration candidate (26) détermine les angles entre les éléments, et les valeurs des angles peuvent adopter, indépendamment les unes des autres, des valeurs entre deux valeurs limites.

**18.** Produit programme informatique qui est agencé, lorsque le programme est exécuté par un ordinateur, pour exécuter les étapes du procédé selon l'une quelconque des revendications précédentes.

Fig 1

Fig 2

Element i

Element i + 1

$x_{i+1}$

Fig 3

Fig 5a

Fig 5b

EP 2 090 137 B1

Fig 5c

Fig 5d

Fig 6a

Fig 6b

Fig 7a

Fig 7b

## SPL re Mix

## Position 6

## Position 8

## Position 10

Fig 8a

Fig 8b

Fig 9a

Fig 9b

Fig 9c

Fig 10a

Fig 10b

Fig 11

Fig 12

**EP 2 090 137 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- EP 1523221 A2
- GB 2259426 A
- US 2005031135 A1
- US 5233664 A

### Non-patent literature cited in the description

- **H. STAFFELDT.** Prediction of sound pressure fields of loudspeaker arrays from loudspeaker polar data with limited angular and frequency resolution. *108th Convention of the Audio Engineering Society,* 2000
- **BILL WEBB et al.** Advances in line array technology for live sound. *AES UK 18th Conference: Live Sound,* 01 April 2003
- **J.E. DENNIS ; J. VIRGINIA.** Derivative-free pattern search methods for multidisciplinary problems. American Institute of Aeronautics and Astronautics, 1994, 922-932
- Analysis of generalized pattern searches. **C. AUDET ; J. DENNIS.** TR00-07 Department of Computational & Applied Mathematics. Rice University